**Europäisches Patentamt**

(19) **European Patent Office**

**Office européen des brevets**

(11) Numéro de publication: **0 083 303**
**B1**

(12) **FASCICULE DE BREVET EUROPEEN**

(45) Date de publication du fascicule du brevet: **24.02.88**

(51) Int. Cl.⁴: **G 04 F 5/06,** G 04 G 3/02, H 03 L 1/02

(21) Numéro de dépôt: **82810540.3**

(22) Date de dépôt: **13.12.82**

(54) Base de temps à quartz compensée en température et montre utilisant la base de temps.

(30) Priorité: **17.12.81 CH 8060/81**

(43) Date de publication de la demande:
**06.07.83 Bulletin 83/27**

(45) Mention de la délivrance du brevet:
**24.02.88 Bulletin 88/08**

(84) Etats contractants désignés:
**DE FR GB** ·

(56) Documents cités:
**EP-A-0 019 591**
**EP-A-0 032 358**
**EP-A-0 032 359**
**WO-A-81/01888**
**DE-A-2 947 721**
**GB-A-2 002 982**
**GB-A-2 004 155**
**US-A-3 423 609**
**US-A-4 464 061**

**JEE, vol. 16, no. 154, octobre 1979, pages 24-27, Tokyo, JP. Y. AKAHANE: "New twin quartz system revolutionizes timekeeping accuracy"**

(73) Titulaire: **ASULAB S.A.**
**Faubourg du Lac 6**
**CH-2501 Bienne (CH)**

(72) Inventeur: **Dinger, Rudolf**
**Charrières 7**
**CH-2024 St-Aubin (CH)**
Inventeur: **Michel, Jean-Georges**
**Observatoire 44**
**CH-2000 Neuchatel (CH)**
Inventeur: **Leuenberger, Claude-Eric**
**Plan 9**
**CH-2000 Neuchatel (CH)**

(74) Mandataire: **Barbeaux, Bernard et al**
**ICB Ingénieurs Conseils en Brevets SA Passage Max. Meuron 6**
**CH-2001 Neuchâtel (CH)**

(56) References cited:
**PATENTS ABSTRACTS OF JAPAN; vol. 3, no. 107, 8 septembre 1979, page 154E136**

**10ème CONGRES INTERNATIONAL DE CHRONOMETRIE, no. 3, septembre 1979, pages 177-182, Genève, CH. Y. AKAHANE: "A highly precise wrist watch with two quartz oscillators"**

0 083 303

(56) References cited:
**JAHRBUCH DER DEUTSCHEN GESELLSCHAFT FÜR CHRONOMETRIE E.V., vol. 28, 1977, pages 9-15, Stuttgart, DE.H. EFFENBERGER: "Digitale Temperaturkompensation von Schwingquarz-Oszillatoren mit automatischem Frequenzabgleich"**

## Description

La présente invention a pour objet une base de temps à quartz compensée en température, et une montre utilisant la base de temps.

De façon plus précise, la présente invention concerne une base de temps à quartz notamment, mais non limitativement, pour une montre électronique dans laquelle la compensation de l'effet de température sur la fréquence délivrée par la base de temps est obtenue en utilisant deux résonateurs à quartz pour réaliser la base de temps.

Il est bien connu que les montres électroniques actuelles ont une très grande précision de marche. Cependant dans ces montres, la base de temps est constituée par un oscillateur comportant un résonateur à quartz. Or, il est bien connu que la fréquence délivrée par l'oscillateur, qui est un général de l'ordre de 32 kHz, dépend de la température. En conséquence, le quartz a une fréquence bien précise pour une température donnée mais lorsqu'on s'écarte de cette température, la fréquence délivrée par le quartz varie. Par exemple, pour une base de temps dans laquelle le quartz donne la fréquence de référence pour une température de 25° Celsius, à des températures de 0° à 50° Celsius, l'erreur de marche peut atteindre 20 ppm ou plus.

Il est donc particulièrement intéressant pour produire des montres ayant une erreur de marche aussi réduite que possible de compenser l'effet de la température sur la fréquence délivrée par le quartz de la base de temps. On connaît actuellement trois systèmes qui pour cela mettent en oeuvre deux résonateurs à quartz.

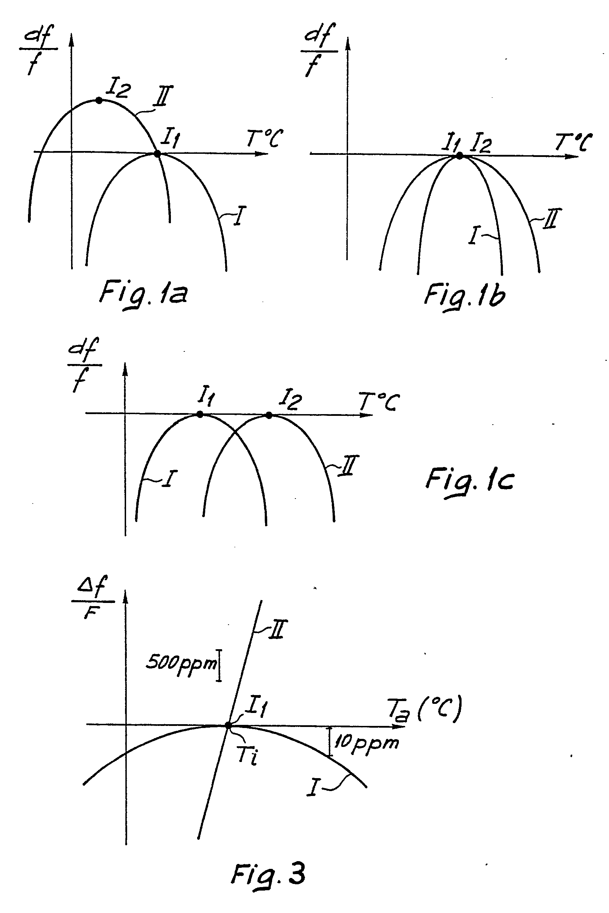

Les figures 1a à 1c illustrent ces trois principes de compensation. Dans le cas des figures 1a et 1b, les deux oscillateurs comportent chacun un quartz travaillant indépendamment. La différence entre ces deux procédés résulte de caractéristiques thermiques des deux quartz. Sur ces figures, on a représenté en abscisse la température T et en ordonée les variations relatives de la fréquence. Dans le cas du procédé de la figure 1a connu notamment grâce aux demandes de brevets européen et japonais publiées respectivement sous les numéros 0 032 358 et 54—85 766, le premier quartz a une caractéristique I telle que son point d'inversion $I_1$ coïncide avec un point de la caractéristique II du deuxième quartz. Ce deuxième quartz présente un point d'inversion $I_2$ qui ne joue aucun rôle particulier en lui-même. En outre, il est nécessaire que les coefficients de température du deuxième ordre $\beta$, c'est-à-dire les coefficients des termes en $T^2$ dans la formule qui donne les variations de la fréquence en fonction de la variation de température soient égaux ou pratiquement.

Dans le cas du système de compensation de la figure 1b qui est décrit dans la demande de brevet GB 2 004 155, les deux caractéristiques I et II des deux quartz doivent présenter des points d'inversion $I_1$ et $I_2$ confondus, c'est-à-dire que pour les deux quartz, la température d'inversion et la fréquence d'inversion doivant être les mêmes. En outre, il est nécessaire que le coefficient $\beta 1$ du premier quartz soit égal au double du coefficient $\beta 2$ du deuxième quartz.

Dans le mode de compensation illustré par la figure 1c, les deux quartz qui peuvent soit être montés en parallèle dans un même oscillateur comme le suggère le brevet US 3463 945, soit être associés à des circuits d'entretien différents comme dans la demande de brevet GB 2 002 982, ont des points d'inversion $I_1$ et $I_2$ sensiblement au même niveau est des coeffic ients de température du deuxième ordre pratiquement égaux. D'autre part, les quartz diovent être choisis de façon que leurs poins d'inversion ne soient pas trop éloignés l'un de l'autre pour obtenir une bonne compensation thermique mais suffisamment quand même pour que cette compensation ait lieu dans une plage d'utilisation assez large.

Donc dans tous les cas, si l'on veut avoir un effet de compensation en température acceptable, il est nécessaire de procéder à un appariage rigoureux des deux résonateurs et cet appariage est particulièrement difficile du fait que les caractéristiques thermiques de ces derniers doivent répondre à au moins deux conditions. Il s'ensuit que munir une montre de l'un de ces systèmes de compensation équivaut à en augmenter dans une large mesure le prix de revient.

On connaît par ailleurs, notamment grâce à la demande de brevet WO 81/01888, des montres dans lesquelles les variations de fréquence de l'oscillateur sont comepensées en utilisant un défecteur de température à caractéristique non linéaire, qui pour être suffisamment sensible, ne peut pratiquement pas être autre chose qu'une thermistance. Ce détecteur est associé à d'autres éléments tel qu'une source de fréquence piezo-électrique, et notamment une capacité variable pour former un circuit de détection fournissant un signal digital représentatif de la température qui est ensuite linéarisé et employé par un circuit de correction pour corriger la marche de la montre en agissant au niveau du diviseur de fréquence.

En plus du fait que l'on est tenu de linéariser le signal produit par le circuit de détection, cette solution présente plusieurs inconvénients.

Tout d'abord, les caractéristiques thermiques des thermistances qui sont utilisées ne peuvent pas être reproduites avec précision et la présence d'un condensateur variable, nécessairement de volume réduit, ne peut pas suffire pour permettre de compenser correctement, dans tous les cas et pour toute la plage de température voulue, les différences relativement importantes qu'il peut y avoir d'une thermistance à l'autre en ce qui concerne ces caractéristiques. Par conséquent, on a le choix entre se contenter d'une compensation thermique qui, la plupart du temps, ne sera que grossière, procéder à un appariage là encore rogoureux entre la thermistance et le résonateur, ou bien prévoir des moyens d'ajustement beaucoup plus compliqués, comme par exemple une pluralité de condensateurs que l'on pourra brancher ou mettre hors circuit individuellement et que l'on sélectionnera en fonction de la caractérisique de chaque thermistance, ce qui, bien entendu, rend le circuit de la montre plus encombrant et augmente son prix de revient.

D'autre part, vu que le résonateur est encapsulé sous vide et que la thermistance, elle, ne l'est pas, ces deux éléments ne sont pas soumis exactement à la même température.

Enfin, étant donné qu'un quartz et une thermistance ne vieillissent pas de la même façon, il est clair que la compensation deviendra de moins en moins bonne au cours du temps.

La présente invention a pour but de fournir une base de temps munie d'une très bonne compensation thermique qui peut être utilisée avantageusement dans une montre et, en particulier, une base de temps qui ne nécessite ni un appariage rigoureux de résonateurs, ni un circuit électronique compliqué qui pourrait être beaucoup plus difficile à réaliser, consommer nettement plus d'énergie et occuper une surface beaucoup plus importante sur un circuit intégré qu'une base de temps de montre classique.

Pour atteindre ce but, la présente invention utilise, dans la base de temps selon la priambule de la revendication 1, les moyens figur and dans la partie caractérisante de cette revendication.

Le coefficient de dépendance par rapport à la température du deuxieme résonateur est de préférence très supérieur à celui du premier résonateur.

L'écart de fréquence entre les deux résonateurs est sensiblement proportionnel à la température du système et permet donc de mesurer la température et ensuite de corriger l'écart de fréquence du premier résonateur. Dans le cas particulier, mais fréquent, où le premier résonateur présente une relation sensiblement quadratique entre la variation relative de fréquence et de la variation de température, une solution particulièrement bien adaptée est la suivante:

Ou élabore un signal de battement entre le premier et le deuxième signal délivrés par les deux résonateurs à quartz et on élabore un signal compor'tant un nombre d'impulsions $N_1$ égal au nombre d'impulsions du signal de battement pendant un temps donné $T_1$. On élabore un deuxième signal de correction représentatif du carré du nombre d'impulsions $N_1$. Cela donne un signal ayant $N_2$ impulsions représentatif du carré de l'écart de la température par rapport à la température de référence du premier oscillateur en considérant que la fréquence du premier oscillateur est relativement indépendante de la température. Puis, en réponse à ce signal comport'ant les $N_2$ impulsions, on ajuste la fréquence du signal délivre par le premier oscillateur.

Soit cet ajustement consiste à agir sur le circuit d'entretien du résonateur, c'est-à-dire par exemple à régler la valeur d'un trimmer dans le circuit d'entretien; soit ce réglage consiste à agir sur un diviseur associé au premier oscillateur qui compte, par exemple, normalement 32.768 impulsions délivrées par le premier oscillateur pour délivrer chaque période d'une seconde du signal horaire. Cette action consiste, toutes les $T_T$ secondes, à supprimer $N_2$ des 32.768 impulsions pour délivrer une période ajustée du signal horaire. Donc toutes les $T_T$ secondes, une période de "une seconde" est raccourcie.

L'invention concerne encore une montre utilisant ladite base de temps qui permet en outre l'affichage de la température ambiente.

De toute façon l'invention sera mieux comprise à la lecture de la description qui suit de plusieurs modes de réalisation de l'invention donnés à titre d'exemples non limitatifs. La description se réfère aux figures annexées dans lesquelles:

les figures 1a à 1c, déjà décrites, illustrent trois procédés connus de compensation thermique d'un oscillateur à quartz, ces figures donnant la caractéristique thermique des deux quartz utilisés avec, en abscice, la température T et, en ordonnée, la variation relative de fréquence des résonateurs.

la figure 2 est un schéma simplifiée montrant l'ensemble de la base de temps munie de sa compensation thermique selon l'invention;

la figure 3 est un diagramme montrant les caractéristiques thermiques du quartz horloger et du senseur de température utilisés dans le circuit de la figure 2 en fonction de la température et de la variation relative de fréquence de ces résonateurs;

la figure 4a est un schéma plus détaillé d'un premier mode de réalisation de l'invention dans lequel la correction se fait en agissant sur le diviseur, et le résonateur a une fréquence qui dépend quadratiquement de la température;

la figure 4b est un diagramme des temps illustrant le fonctionnement du dispositif représenté sur la figure 4a;

la figure 4c est un schéma simplifié du circuit de commande du dispositif de la figure 4a;

la figure 5a est un schéma détaillé d'un exemple de réalisation du générateur de battement;

la figure 5b est un diagramme temporel illustant le fonctionnement du générateur de battement de la figure 5a;

la figure 6a est un schéma partiel illustrant plus en détail la façon dont on peut élaborer les $N_2$ impulsions représentatives du carré de la variation de température;

la figure 6b est un diagramme temporel illustrant le fonctionnement du circuit de la figure 6a;

les figures 7a à 7c illustrent un premier mode d'ajustement de la fréquence délivrée par le premier oscillateur;

— la figure 8 est un schéma illustrant un deuxième mode de réalisation du circuit d'adjustement de la fréquence délivrée par le premier oscillateur;

la figure 9, est un schéma simplifié d'une montre munie de la base de temps selon figure 4a et permettant de plus l'affichage de la température; et

la figure 10 illustre un autre mode de réalisation de la base de temps dans laquelle l'oscillateur horloger a une loi polynomiale de dépendance de la fréquence par rapport à la température.

La description qui suit concerne plus particulièrement le cas où la base de temps est utilisé dans une montre électronique du type digital ou analogique. Il apparaîtra cependant immédiatement à l'homme de métier que le système de compensation thermique utilisé pourrait être parfaitement adapté à d'autres bases de temps telles que celles qu'on peut utiliser en liaison avec des micro-processeurs ou dans des ordinateurs. En effet, comme cela sera montré ultérieurement, la compensation ne dépend nullement de façon critique de la fréquence de référence délivrée par l'oscillateur à quartz que l'on veut stabiliser en température.

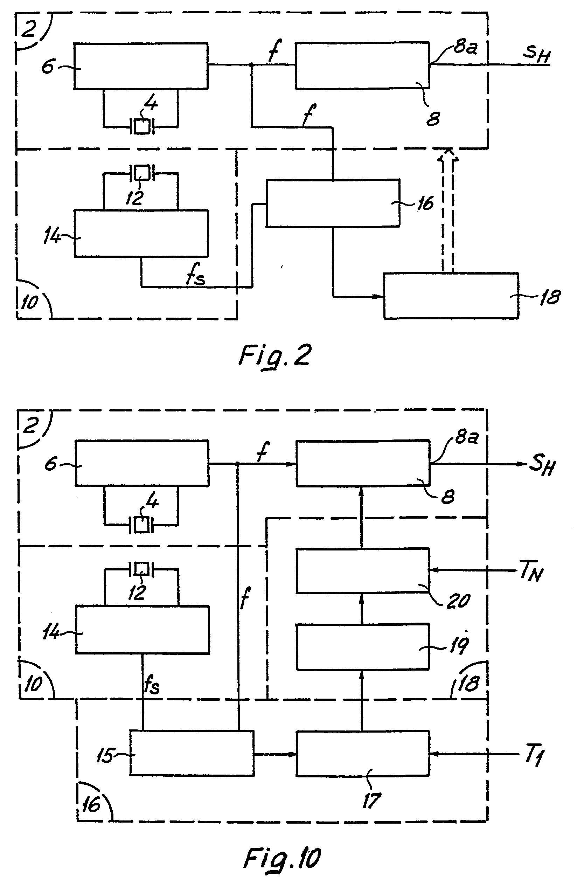

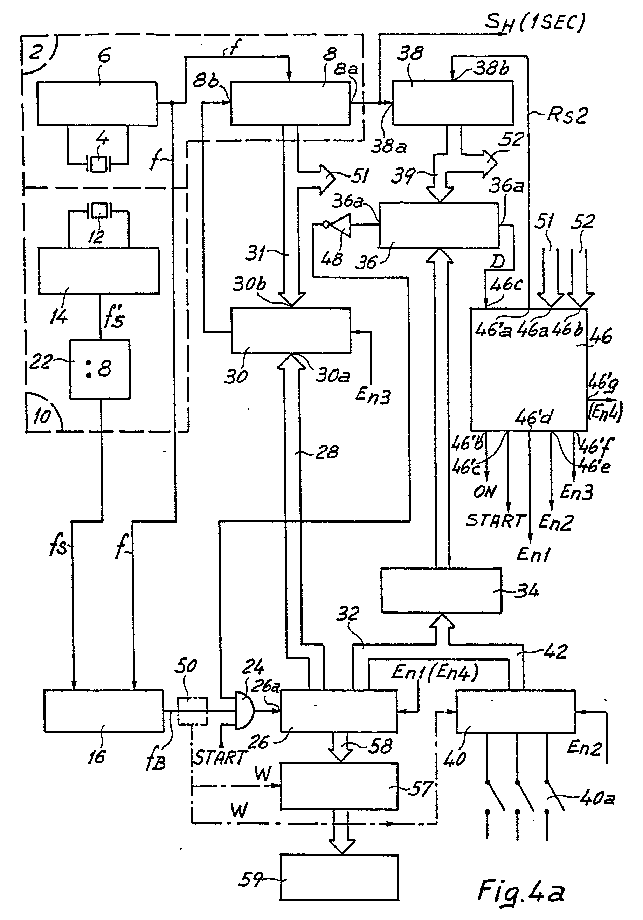

Comme le montre la figure 2, la base de temps comprend tout d'abord un premier générateur de fréquence 2 constitué de façon classique par un oscillateur formé d'une résonateur à quartz 4 associé à un circuit d'entretien 6 qui délivre à sa sortie un signal périodique de fréquence fo et par un diviseur de fréquence 8 qui reçoit à son entrée le signal de fréquence fo pour délivrer un signal horaire $S_h$ de période une seconde. A titre d'exemple, le résonateur à quartz 4 est un résonateur du type diapason qui délivre un signal de fréquence normale 32.768 Hz comme cela est habituel dans les bases de temps pour montres électroniques. Sur la figure 3, la courbe I représente la caractéristique thermique typique d'un tel quartz. En ordonnée, on a porté la variation relative de la fréquence et en abscisse la température en degré Celsius. La caractéristique I a une forme de courbe quadratique dont le sommet $I_1$ constitue le point d'inversion. Au point $I_1$ correspond la température d'inversion $T_i$ qui vaut par exemple 25° Celsius et la fréquence de base f du résonateur qui vaut par exemple 32768 Hz.

Plus précisément, la fréquence f de ce quartz en fonction de l'écart de température T entre la température ambiante $T_a$, et la température d'inversion $T_i$ est donnée par la relation:

$$f(T)=f_o (1+\alpha T_o T+\beta_o T^2+\gamma_o T^3+...) \qquad (1)$$

dans laquelle $f_o$, $\alpha_o$, $\beta_o$ et $\gamma_o$ sont les constantes. Il s'agit de caractéristiques parfaitement classiques d'un résonateur à quartz horloger. Dans le cas envisagé le diviseur 8 est constitué par un certain nombre d'étages de division binaire, la sortie $8_a$ du dernier étage délivrant le signal horaire $S_H$ périodique de période 1 seconde.

Le deuxième générateur de fréquence 10 est constitué par un résonateur à quartz 12 et un circuit d'entretien 14. Ce générateur de fréquence délivre un signal périodique de fréquence $f_s$. En fait, le résonateur 12 est un senseur de température qui présente des caractéristiques tout à fait particulières. Comme le montre la figure 3, sa caractérisique II de variation de fréquence en fonction de la température est sensiblement une droite du moins dans le domaine de température envisagé et le taux de dépendance vis-à-vis de la température est très élevé. En outre, la caractéristique II passe par le point d'inversion $I_1$ de la caractéristique I du résponateur horloger. Sur la figure 3, les échelles pour représenter les ordonnées (ppm) sont différentes pour rendre la figure plus lisible.

Les deux valeurs numériques qui y sont mentionnées permettent de mieux se rendre compte des lois réelles de variation relative de fréquence en fonction de la température. Le résonateur 12 présente une caractéristique de fréquence en fonction de la température qui est donnée par la formule générale suivante.

$$f_s(T)=f'_o (1+\alpha_s T+\beta_s T^2)$$

Dans cette formule, $\alpha_s$ est supérieur à $\beta_s$ de plusieurs ordres de grandeur et $\beta_o$ est inférieur de plusieurs ordres de grandeur à $\alpha_s$. En première approximation, on peut donc considérer que $f_s$ est dans le domaine de température considéré une droite. En outre, à la température d'inversion, la fréquence de ce résonateur est un multiple entier de la fréquence normale du résonateur 4. Dans le cas particulier, ce rapport est égal à 8. De préférence, les coefficients $\alpha_s$ et $\beta_s$ ont les valeurs suivantes:

$$\alpha_s=34 \text{ ppm/°C}$$

$\beta_s=20. 10^{-3}$ ppm/°C² résonateur 12 présentant les caractéristiques énoncées précédemment est selon l'invention un résonateur du type diapason qui est excité en torsion. Ce résonateur est taillé de telle manière que ses faces principales soient perpendiculaires à un axe Z' faisant un angle de 2° avec l'axe optique Z du quartz et que ses branches soient parallèles à l'axe X du quartz. La largeur d'une branche du diapason vaut par exemple 0,230 mm et son épaisseur 0,125 mm. Il y a bien sûr d'autres manières de réaliser un tel senseur de température à l'aide d'un résonateur à quartz. De tels résonateurs à quartz sont décrits dans la demande de brevet européen no. 81.810333.5 (publiée le 31.03.82).

Les signaux, respectivement de fréquence f venant de l'oscillateur horloger 4, 6 et de fréquence $f_s$ venant du senseur 14 sont appliqués aux entrées d'un circuit 16 qui délivre sur sa sortie un signal, représentant de l'écart de température T. Si l'on considère, compte tenu des valeurs respectives de $\alpha_s$ et $\beta_s$, que la caractéristique thermique du résonateur senseur thermique est quasi linéaire dans la zone de température considérée (par exemple de 0 à 50° Celsius) et que, compte tenu du fait que la dépendance de la fréquence du quartz horloger vis-à-vis de la température est beaucoup plus faible que celle du quartz thermomètre, la fréquence du résonateur 4 est indépendante de la température, on peut dire en première approximation, que cette différence de fréquence représente une quantité proportionnelle à l'écart de température mesurée par le senseur thermique 14, l'oscillateur 4, 6 en constituant la référence. Dans le circuit d'ajustement 18, on élabore un signal d'ajustement en réponse au signal, représentatif de l'écart de température.

Comme on l'expliquera ultérierement, cet ajustement peut se faire soit en agissant sur le diviseur 8 soit en agissant sur le circuit d'entretien 6 de l'oscillateur 4. C'est pourquoi, la flèche sortant du circuit 18 est dirigée vers l'ensemble du générateur de fréquence 2.

La description précédente montre déjà les avantages principaux du principe de compensation utilisé dans l'invention. La figure 3 montre clairement qu'il n'y a pas de problème d'appariage à proprement parlé entre les deux résonateurs. En effet, la seule condition imposée est que la caractéristique II du senseur thermique passe par le point d'inversion $I_1$ de la caractérisique 1 du quartz horloger. Cette condition est facilement remplie du ait qu'il est aisé de déplacer la droite ou la quasi-droite II parallèment à l'axe des ordonnées, par exemple en agissant sur un trimmer associé au circuit d'entretien 6 ou par d'autres moyens qui seront explicités ultérieurement. Par ailleurs, on peut ajouter qu'on conçoit aisément que, compte tenu de la très forte dépendance vis-à-vis de la température de la caractéristique II du senseur thermique vis-à-vis de cette même dépendance de a caractéristique 1 de l'oscillateur horloger, le fait que la caractéristique II ne passe pas exactement par le point d'invertion $I_1$ n'aura guère d'effet sur la correction apportée.

En outre, le système de compensation utilise effectivement un senseur thermique sand que celui-ci présente les inconvénients habituellement présentés par de tels capteurs. En effet, il est évident que tout appareil de mesure pour convertir une grandeur physique dans une autre, doit comporter une référence absolue indépendante de la grandeur physique à mesurer. Par exemple dans le cas où le senseur thermique délivre un signal de mesure sous forme d'une tension électrique, il est nécessaire, pour effectuer la mesure, de disposer d'une référence de tension indépendante de la température. Or, cela pose de nombreux problèmes. Dans le cas de l'invention, il apparaît clairement que c'est le générateur de fréquence 2 qui joue le rôle de référence pour le senseur thermique 10. D'une part cela permet de supprimer un composant. D'autre part, compte tenu de la sensibilité à la température du senseur, le générateur de fréquence peut être considéré comme une référence pratiquement indépendante de la température. En outre, la mesure de température ainsi effectuée se présente sous la forme d'un signal périodique, c'est-à-dire sous une forme quasi-digitale, or on sait que c'est cette forme de signal de mesure qu'il est le plus facile de traiter.

La figure 10 illustre de façon plus détaillée un mode de réalisation de la base de temps dans le cas le plus général où la relation entre les variations relatives de fréquence du résonateur 4 en fonction de l'écart de la température est une fonction polynomiale quelconque du type mentionné précédemment (relation 1).

Sur cette figure, on retrouve le premier générateur de fréquence 2 identique à celui de la figure 2, et le deuxième générateur de fréquence 10 également identique à celui de la figure 2. Le circuit 16 de la figure 2 comprend un générateur de battement 15 et un compteur 17. Le générateur de battement reçoit sur ses entrées le signal de fréquence $f_a$ venant de l'oscillateur 4, 6 et le signal de fréquence $f_S$ venant de l'oscillateur 12, 14. Il délivre sur sa sortie un signal de battement de fréquence $f_B$ qui représente donc la différence entre les fréquences f et $f_S$. Le competur 17 compte le nombre de périodes $N_1$ du signal $f_B$ pendant un temps prédéterminé $T_1$. Le nombre $N_1$ vaut $f_B T_1$. Il est donc bien proportionnel à l'écart de température dans les approximations faites précédemment. Ce nombre $N_1$ est introduit dans un circuit 19 qui fait correspondre une valeur de $N_1$ à une valeur de correction d'ajustment à appliquer au générateur de fréquence 2 pour compenser l'effet de l'écart de température T mesuré par le circuit 16. Dans le cas de la figure 10, cette correction ou cet ajustement de fréquence est obtenu en agissant sur le diviseur 8. Ce diviseur, pour délivrer une période de une seconde du signal $S_H$, compte un certain nombre d'impulsions successives du signal f délivré par l'oscillateur 4,6. Dans le cas, où cet oscillateur a une fréquence de 32768 Hz à sa température d'inversion, le compteur 8 doit donc compter normalement 32768 impulsions pour délivrer une période de une seconde. L'adjustment consiste à enlever $N_1$ impulsions aux 32768 impulsions normalement comptées pour définir une période de une seconde. On obtient ainsi une période ajustée qui est raccourcie de

$$\frac{N2}{32768}$$

seconde.

Cette opération n'est pas effectuée sur toutes les périodes d'une seconde du signal $S_H$ mais seulement sur des périodes séparées par un intervalle de temps de $T_N$ secondes. Cette période de $T_N$ secondes dépend de la résolution désirée pour l'adjustement en fréquence. Le circuit 19 a pour but d'élaborer ce nombre $N_2$ en fonction de la valeur $N_1$ représentative de l'écart de température et de la période $T_N$ d'adjustment choisie. Le circuit 20 qui reçoit le nombre $N_2$ permet d'enlever le nombre $N_N$ aux périodes comptées par le compteur 8. Le signal de période $T_N$ sert à commander la suppression des $N_2$ périodes aux instants prévus. Le circuit 19 peut être soit une mémoire morte, soit un micro-processeur. Ce circuit doit faire la relation entre la valeur du nombre $N_1$ et la valeur numérique T de l'écart de température; calculer la valeur numérique de

$$\frac{\Delta f}{f}$$

(relation 1) pour une valeur particulière de T; en une valeur $N_2$ qui tient compte de la période $T_1$ et de la période $T_N$.

Si l'on accepte que le circuit 19 soit adapté à seule base de temps bien individualisée, le circuit 19 peut être une mémoire morte.

En effet, si les périodes $T_1$ et $T_N$ sont fixées définitivement et si les paramètres des deux quartz particuliers utilisés sont fixés ($f_o$, $\alpha_o$, $\beta_o$, $\gamma_o$, $f'_o$, $\alpha_s$, $\beta_s$), on comprend qu'il est possible d'établir une correspondance univoque entre les valeurs de $N_1$ et la valeur associée $N_2$ pour toute la plage de température. La mémoire morte est alors chargée avec le tableau de correspondance entre les valeurs de $N_1$, formant des adresses, et les valeurs de $N_2$. Si au contraire, on veut que le circuit 19 puisse s'adapter à différentes bases de temps, le circuit 19 est un micro-processeur. Celui-ci est pré-programmé pour effectuer les trois opérations mentionnées ci-dessus.

Au moment du montage circuit 19 dans une base de temps particulière, on introduit les valeurs correspondantes des paramètres ($f_o$, $\alpha_o$, $\beta_o$, $\gamma_o$, $f'_o$, $\alpha_s$, $\beta_s$). En fonctionnement, le micro-processeur calcule la valeur du nombre $N_2$ à partir de la valeur du nombre $N_1$ appliquée à son entrée. Bien entendu, le circuit 19 pourrait également commander la capacité d'un condensateur variable pour ajuster directement la fréquence f du signal délivré par l'oscillateur.

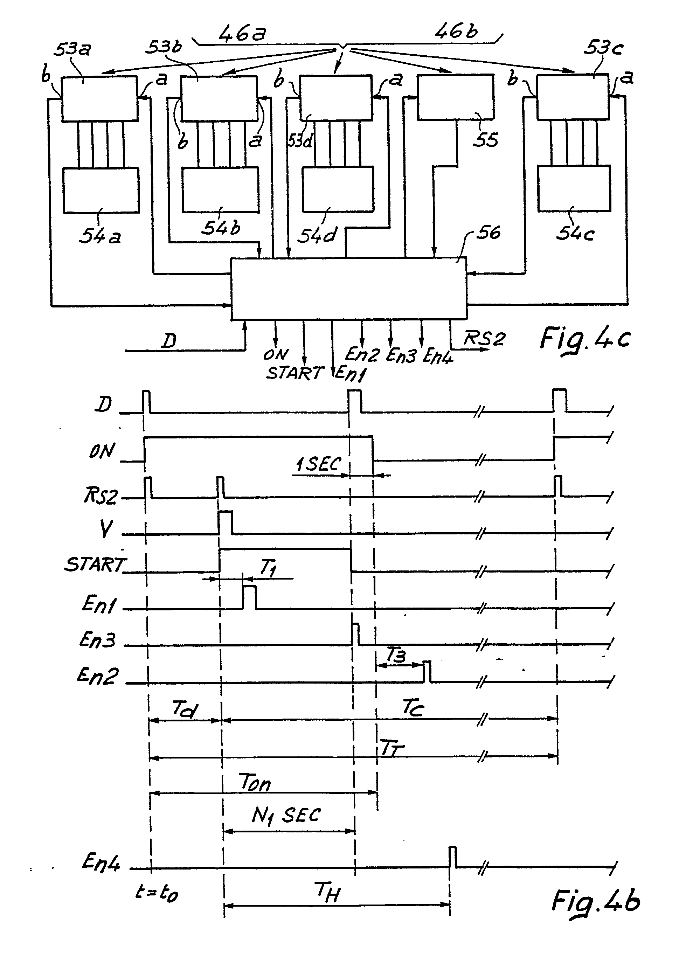

Sur la figure 4a, on a représenté plus en détail un mode de réalisation préféré de la base de temps dans le cas particulier où le résonateur 4 présente une relation quadratique entre la variation relative de la fréquence et la variation de température. La fréquence f peut alors s'écrire $f(T)=f_o(1+\beta_o T^2)$. Par exemple $\beta_o=-34.10^{-9}$ °C$^{-2}$.

Sur cette figure, on retrouve le générateur de fréquence 2 avec son résonateur 4, son circuit d'entretien 6 et son diviseur 8 qui délivre sur sa sortie 8a le signal horaire $S_H$ qui est un signal de période une seconde. L'oscillateur 10 comprend le résonateur 12 identique à celui de la figure 2 et le circuit d'entretien 14 également identique à celui de la figure 2 qui délivre un signal de fréquence $f'_s$. L'oscillateur 10 comporte de plus un diviseur par 8 référence 22 qui divise le signal de fréquence $f'_s$ délivré par le résonateur par 8 pour donner le signal de fréquence $F_s$ de la figure 2. On rappelle que la fréquence normale du signal délivré par le résonateur 12 est 8 fois plus élevée que celle du signal délivré par le résonateur 4 ($f'_o=8f_o$). On voit ainsi que la fréquence du signal délivrée par le résonateur n'est pas critique. Il suffit de choisir le facteur de division du diviseur 22 pour retrouver des fréquences $f_s$ et f égales. Il en résulte qu'à la température d'inversion, les fréquences f et $f_s$ sont égales. Les deux signaux $f_s$ et f sont introduits dans le générateur de battement 16 qui délivre à sa sortie le signal de battement de fréquence $f_B$. Ce signal $f_B$ est introduit à l'une des entrées d'une porte ET 24 dont la sortie est reliée à une entrée d'horloge 26a d'un compteur principal 26. Les sorties d'état du compteur principal 26 sont reliées par le BUS 28 à une première série d'entrées de comparaison 30a d'un premier comparateur 30. La deuxième série d'entrées 30b du comparateur 30 est reliée aux sorties d'état du diviseur 8 par le BUS 31. Les sorties d'état du compteur principal sont également appliquées par un BUS 32 aux entrées d'une mémoire commandable 34. Les sorties de la mémoire 34 sont appliquées à une première série d'entrées d'un deuxième comparateur 36. Par ailleurs, le signal horaire $S_H$ de période une seconde délivré par la sortie 8a du diviseur de la montre 8 est appliqué à l'entrée d'horloge 38a d'un diviseur basse-fréquence 38. Les sorties d'état de ce diviseur 38 sont appliquées par un BUS 39 à la deuxième série d'entrées du comparateur 36. La base de temps comprend encore un circuit 40 d'élaboration d'une période $T_C$ programmable par les moyens symbolisés par les commutateurs 40a. L'état du circuit d'élaboration 40 peut être appliqué à la première série d'entrées de la mémoire commandable 34 par le BUS 42. Enfin, la base de temps comprend un circuit de commande 46 qui reçoit sur ses entrées 46a et 46b les signaux appliqués sur les sorties d'état des diviseurs 8 et 38 par les BUS 51 et 52.

Il reçoit également sur une entrée 46c un signal délivré par la sortie de coïncidence 36a du comparateur 36. Il délivre sur sa sortie 46'a un signal RS2 appliqué à l'entrée 38b de remise à zéro du diviseur 38. Ses sorties 46'b à 46'f délivrent respectivement les signaux ON, START, $E_{n1}$, $E_{n2}$ et $E_{n3}$.

On va maintenant décrire en liaison avec les figures 4a et 4b le fonctionnement du circuit de la figure 4a. Si l'on se place à un instant précédant l'instant t0 correspondant au début de l'initialisation d'un cycle de fonctionnement, seul l'oscillateur 4, 6, le diviseur 8, et le diviseur 38 fonctionnent. Par ailleurs, la valeur de la période $T_c$ est contenue dans la mémoire commandable 34. Lorsque le comparateur 36 détecte l'égalité entre le contenu du diviseur 38 et le contenu de la mémoire 34, il émet un signal D vers le circuit de commande 46 et vers la porte 24, via un inverseur 48. Ce signal D est sans effet puisqu'aucun autre signal n'est appliqué à cette porte. Par ailleurs, les autres circuits principaux à savoir, l'oscillateur 10, le générateur de battement 16, le comparateur 30, le compteur principal 26 et le circuit 40 d'élaboration de la période $T_c$, sont déclenchés. A l'instant d'apparition du signal D, le circuit de séquencement 46 applique au diviseur 38 le signal de remise à zéro RS2 et il applique aux circuits initialement déclenchés le signal "ON" pour les rendre actifs. Lorsque le circuit de commande 46 détecte que le nombre d'impulsions horaires comptées par le diviseur 38 est égal à la période de démarrage $T_d$ prédéterminée, il applique le signal "START" à la porte ET 24 et le signal RS2 au diviseur 38 qui est ainsi remis à zéro. Par ailleurs, la sortie de comparaison 36a qui délivre également le signal D est appliquée à l'une des entrées de la porte ET 24 par l'intermédiaire de l'inverseur 48. Comme à cet instant les deux groupes d'entrées du comparateur 36 sont à des valeurs différentes, le signal D est au niveau logique "0". A la sortie de l'inverseur 48 on a donc un signal logique de niveau "1". La porte 24 est donc ouverte. Le signal de battement $f_B$, délivré par le générateur de battement 16, est donc appliqué à l'entrée d'horloge 26a du compteur principal 26. Lorsqu'une durée prédéterminée $T_1$ s'est écoulée après le début du signal "START", le circuit de commande 46 applique une impulsion $E_{n1}$ au compteur 26. Cela a pour effet de transférer dans la mémoire 34, par l'intermédiaire du BUS 32, le contenu actuel du compteur 26. Soit $N_1$ le contenu de ce compteur. $N_1$ représente donc le nombre d'impulsions du signal de fréquence $f_B$, pendant le temps $T_1$, c'est-à-dire qu'il représente une grandeur proportionnelle à la température mesurée par l'oscillateur 10, l'oscillateur 4, 6 étant pris comme référence. Le compteur 26 continue à compter les impulsions du signal $f_B$ et le comparateur 36 compare le contenu de la mémoire 34, c'est-à-dire $N_1$, au contenu du diviseur 38 qui compte les périodes de une seconde délivrées par le diviseur 8. Lorsque le contenu du diviseur 38 devient égal au contenu de la mémoire 34, le signal D passe à la valeur 1 et la porte 24 est donc fermée. Le compteur 26 n'est donc plus incrémenté. On appelle $N_2$ la valeur de son contenu. On comprend que le comparateur délivre le signal D lorsque le diviseur 38 a compté un nombre d'impulsions de période une seconde égal au nombre d'impulsions $N_1$ contenues dans la mémoire 34. En conséquence, à cet instant, le contenu $N_2$ du compteur est égal au nombre entier d'impulsions du signal de battement $f_B$ pendant le temps $T_1 \times N_1$ secondes. Le nombre $N_2$ est donc proportionnel au carré du nombre de périodes du signal $f_B$ pendant le temps $T_1$, c'est-à-dire au carré de l'écart de température. Les sorties d'état du compteur 26 sont reliées en permanence aux entrées 30a du comparateur 30 par le BUS 28. Cependant le comparator 30 n'est activé que lorsque le signal $E_{n3}$ lui est appliqué. En outre, les entrées 30a du comparateur effectuent la complémentation du nombre qui leur est appliqué à 32.768 qui est la fréquence normale du signal délivré par l'oscillateur 4,6. Si l'on considère le cas général d'un oscillateur 4,6 délivrant un signal de fréquence F à la température d'inversion, le diviseur 8 doit donc compter N périodes

$$(N = \frac{1}{F})$$

pour délivrer à sa sortie une période de une seconde. Lors de l'opération décrite précédemment les entrées 30a du comparateur font donc une complémentation à N. Le signal D est par ailleurs appliqué à l'entrée 46c du circuit de commande 46. A l'apparition de ce signal le circuit 46 émet précisément le signal d'activation $E_{n3}$ qui active le comparateur 30. Le signal $E_{n3}$ est appliqué immédiatement au début d'une période de une seconde du signal horaire. Lorsque l'entrée 30b représentant le contenu du diviseur 8 est égale au nombre appliqué sur l'entrée 30a du comparateur, celui-ci émet un signal RS1 qui est appliqué à l'entrée de remise à zéro 8b du compteur 8. Comme on l'expliquera ultérieurement, cette opération a pour effet de raccourcir la durée de cette période particulière de une seconde du signal horaire d'une durée de N2/32768 seconde. Une seconde après l'apparition du signal $E_{n3}$ le signal "ON" délivré par le circuit de commande 46 retombe à zéro, ce qui a pour effet de désactiver l'oscillateur 10, le générateur de battement 16 et le comparateur 30. Après une seconde, la suppression du nombre $N_2$ de périodes du signal horaire a été effectuée, c'est-à-dire que la correction a déjà été réalisée. Lorsqu'un temps T3 s'est écoulé après la remise à zéro du signal "ON", le circuit de commande 46 émet un signal $E_{n2}$ qui a pour effet de transférer dans la mémoire 34 le contenu du circuit 40 d'élaboration de la valeur de la période $T_c$. Cette valeur est comparée au contenu du compteur 38. Lorsque le comparateur 36 détecte l'égalité entre les signaux appliqués sur ces deux groupes d'entrée, un signal D est émis vers le circuit de commande. On se retrouve alors dans la même situation qu'à l'instant $t_0$ et une nouvelle période de correction débute. On comprend aisément que la période totale de correction $T_T$ vaut $T_c + T_d$, $T_d$ étant le temps de démarrage du circuit de correction.

La figure 4c illustre un peu plus en détails le circuit de commande 46. Ce circuit a pour but d'élaborer les signaux prévus sur ses sorties sous l'effet du signal D en introduisant convenablement les temporisations. Le circuit de commande reçoit sur ses entrées 46a et 46b les états binaires des sorties binaires des compteurs 8 et 38. Il est donc possible de compter des durées de 1/32768 seconde à 2047 seconde (si le compteur 38 comporte 11 étages binaires de division pour compter $T_c$). Ces valeurs binaires sont appliquées à une première série d'entrées de comparateurs 53a, 53b et 53c. Le circuit comporte également les mémoires 54a, 54b et 54c qui peuvent être préchargées aux valeurs $T_1$, $T_d$ et $T_3$. Elles sont respectivement reliées au deuxième groupe d'entrées des comparateurs 53a, 53b et 53c. Chaque comparateur comporte en outre une sortie de coïncidence $a$ et une entrée d'activation $b$. Le circuit de commande comprend en outre un compteur 55 pour élaborer l'intervalle de une seconde en réponse au signal d'activation appliqué sur son entrée b.

Les signaux d'activation sont émis par un ensemble de séquencement 56 qui reçoit le signal D et les signaux de coïncidence délivrés par les comparateurs.

Le circuit 56 délivre les signaux appliqués sur les sorties 46'a à 46'f du circuit 46. La structure précise du circuit de séquencement découle de façon évidente des explications précédentes et des diagrammes des temps. Il n'est donc pas utile de l'expliquer davantage.

Dans le cas où le quartz horloger 4 présente une relation quasi-quadratique, on voit que les circuits, pour associer le nombre $N_2$ au nombre $N_1$, sont très simples puisqu'ils n'utilisent que des circuits intégrés classiques.

Si l'on revient au circuit simplifié de la figure 2, il est aisé d'établir la correspondance entre le mode de réalisation détaillé de la figure 4a et le mode simplifié de la figure 2. Le circuit 16 de la figure 2, pour l'élaboration du nombre $N_1$, comprend clairement la porte 24, le compteur principal 26 et la mémoire 34. En ce qui concerne le circuit d'adjustement 18 de la figure 2, il se compose des moyens pour élaborer $N_2$ à partir de $N_1$, des moyens pour détecter et élaborer la fin de la période $T_c$ et, d'autre part, des moyens pour retrancher les $N_2$ impulsions. Les premiers moyens comprennent les compteurs 26 et 38, la mémoire 34 et le comparateur 36. Les deuxièmes moyens consistent dans le circuit d'élaboration 40, la mémoire 34, le circuit comparateur 36 et le circuit diviseur 38. Les troisièmes moyens consistent essentiellement dans le comparateur 30 et le diviseur de montre 8. Il ressort clairement de cette constatation que certains des éléments du circuit remplissent une double fonction, c'est en particulier le cas du compteur 26 qui sert à compter à la fois les nombres $N_1$ et $N_2$, de la mémoire 34 qui contient successivement le nombre $N_1$ et la période $T_c$, du comparateur 36 qui compare le contenu du compteur 38 successivement au nombre $N_1$ et au nombre correspondant à la période $T_c$ et du compteur 38 qui sert lui à l'élaboration de temps $N_1$ seconde ainsi qu'à la détection de la fin de la période $T_c$.

En outre il est important de bien comprendre la façon dont cette correction est effectuée à partir de l'élaboration du nombre $N_2$. Cette correction consiste à retrancher le nombre d'impulsions $N_2$ aux impulsions délivrées par l'oscillateur 4,6 nécessaires pour élaborer une période de une seconde du signal horaire $S_H$, et ceci pour une seule période de une seconde toutes les périodes de correction, c'est-à-dire à des instants séparés par la durée $T_T = T_s + T_d$.

On va maintenant expliquer comment on définit la période $T_c$.

On admet tout d'abord que la fonction $f(T)$ est constante, c'est-à-dire que, dans la gamme de température considérée (par exemple 0°C à 50°C), les variations de f sont négligeables par rapport aux variations de la fréquence $f_S(T)$ du signal délivré par le senseur thermique 10. On a alors les relations:

$$f(T) = f_o \quad (f_o = 32.768 \text{ Hz})$$
$$\text{et } f_S(T) = 8 \times f_o (1 + \alpha_S T);$$

$\alpha_S$ étant constant pour un résonateur donné, et T représentant l'écart de température entre la température d'inversion $T_I$ du résonateur 4 et la température ambiante $T_a$.

La fréquence de battement, compte tenu du diviseur 22 est donnée par l'expression suivante:

$$f_B(T) = f_S/8 - f = f_o(1 + \alpha_S T) - f_o = \alpha_S f_o T$$

$N_1$ est le nombre de périodes entières contenues dans le signal $f_B$ pendant le temps $T_1$. On a donc: $N_1 = \text{ent } \{T_1/\alpha_S f_o T/\}$, ent $\{F\}$ représentant la partie entière de la valeur numérique de la fonction F.

Pour obtenir $N_2$, on compte les périodes entières de $f_B$ pendant le temps $N_1$ secondes. On a donc:
$$N_2 = \text{ent } \{N_1 T_1 \alpha_S f_o T\}$$
$$N_2 = \text{ent } \{T_1 \cdot \text{ent } \{T_1 \alpha_S f_o T\} \cdot \alpha_S f_o T\}$$

On pose à nouveau $T_T = T_d + T_c$; $T_T$ représentant la période exacte à laquelle on effectue l'ajustement.

Pour que la marche moyenne de la base de temps sur la période $T_T$ soit à erreur nulle, il faut que:
$$f_o T_T = f T_T + N_2$$
$$f_o T_T = T_T f_o (1 + \beta o T^2) + N_2$$

$$T_T = \frac{N_2}{f_o \beta o T^2}$$

La valeur exacte de $N_2$ vaut $\alpha_S^2 f_o^2 T^2 T_1^2$

$$\text{d'où } T_T = -\frac{\alpha_S^2 f_o^2 T^2 T_1^2}{f_o \beta o T^2} = -\frac{\alpha_S^2}{\beta o} f_o T_1^2$$

c'est-à-dire que, dans cette approximation, $T_T$ est indépendante de la température T.

Si $T_1$ vaut 1 seconde et en reprenant les valeurs numériques de $\alpha_S$, $\beta o$ et f déjà données: $T_T \cong 1114$ secondes.

Il est alors aisé d'en déduire $T_c$. Par exemple, pour le circuit considéré, la période de démarrage $T_d$ vaut 4 secondes.

Si l'on revient au circuit de la figure 4a, on voit que les éléments 40a permettent de préprogrammer la valeur de $T_c$ à la valeur correspondant aux résonateurs à quartz effectivement utilisés ($\alpha_S$, $\beta o$, f).

Si l'on refait les mêmes calculs mais en prenant en considération, le fait que la fréquence f du quartz 4 est de la forme $f = f_o (1 + \beta o T^2)$, et que la fréquence $f'_S$ du senseur 12 est de la forme $f'_S = 8 \times f_o (1 + \alpha_S T + \beta_S T^2)$.

La période $T_T$ est donnée par la relation

$$T_T = -n^2 f_o \frac{[\alpha_S + (\beta_S - \beta o) T]^2}{\beta o (1 + \beta o T^2)^2}$$

formule dans laquelle n est défini ainsi

$$T_1 = -n^2 f_o \frac{\alpha_S + (\beta_S - \beta o) T^2}{\beta o (1 + \beta o T^2)^2}$$

L'expression $\beta o T^2$ étant négligeable devant 1 dans la plage de température considérée, $T_T$ peut s'écrire:

$$T_T = -n^2 f_o \frac{[\alpha_S + (\beta_S - \beta o) T]^2}{\beta o}$$

Cette expression dépend de la température T. Si l'on adopte les valeurs numériques déjà données et si $T_1$ vaut 1 seconde (d'où n = 1), les valeurs de

$T_T$ en fonction de la température ambiante $T_a$ sont données par le tableau suivant:

| $T_a °C$ | $T_T$ (sec.) | |
|---|---|---|
| 0 | 1027 | |
| 10 | 1062 | |
| 20 | 1096 | |
| 25 | 1114 | $T_i = 25°C$ |
| 30 | 1132 | |
| 40 | 1168 | |
| 50 | 1204 | |

Pour tenir compte rigoureusement de cette dépendance de $T_T$, et donc de $T_c$, vis-à-vis de la température ambiante, il serait possible de concevoir le circuit 40 comme un micro-processeur ayant en mémoire ces valeurs. Ce micro-processeur serait commandé par la valeur $N_1$ représentative de l'écart de température entre la température ambiante et la température d'inversion. Cet écart pouvant être positif ou négatif, le circuit comprendrait en plus un détecteur 50 du signe de la fréquence de battement $f_B$. C'est ce qui est représenté en pointillés sur la figure 4a.

Cependant, une telle disposition complique le circuit. On a établi qu'on obtient une très bonne approximation de cette loi de variation en adoptant pour $T_T$ seulement deux valeurs. Une valeur $T_T$-lorsque la température ambiante est inférieure à la température d'inversion; et une valeur $T_T+$ dans le cas contraite.

Pour les valeurs numériques déjà considérées $T_T- = 1059$ secondes, et $T_T+ = 1169$ secondes.

Avec ces valeurs, l'erreur maximale moyenne introduite est de l'ordre de 0,25 ppm pour la gamme de température ambiante de 0°C à 50°C.

Dans ce mode de réalisation correspondant à cette approximation, le circuit de la figure 4a comprend le détecteur de signe 50 qui délivre le signal W selon le signe de la fréquence de battement. Le circuit 40 permet d'élaborer deux valeurs de $T_c$ correspondant respectivement à $T_T-$ et $T_T+$. A chaque correction, c'est le signal W qui détermine laquelle de ces deux valeurs doit être mémorisée dans le circuit 34 à l'apparition du signal $E_{n2}$.

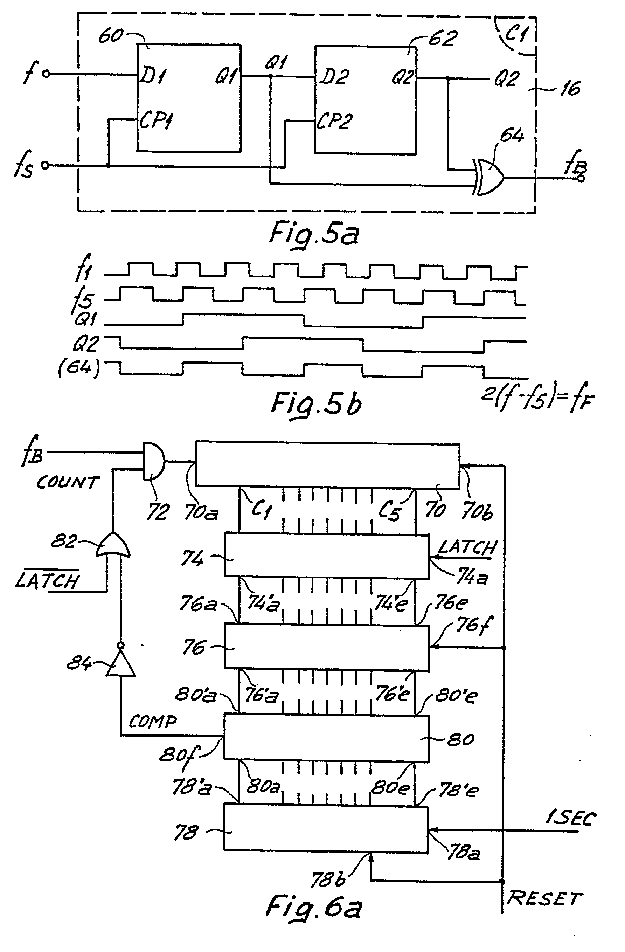

Les figures 5a et 5b illustrent un mode de réalisation du générateur de battement. Il comprend une première bascule 60 de type D avec son entrée d'horloge $CP_1$ et son entrée de commande $D_1$. L'entrée $D_1$ reçoit le signal de fréquence f et l'entrée $CP_1$ le signal de fréquence $f_s$. Le circuit 16 comprend une deuxième bascule 62 de type D dont l'entrée de commande $D_2$ est reliée à la sortie $Q_1$ de la bascule 60 et dont l'entrée d'horloge $CP_2$ reçoit le signal de frequence $f_s$. Enfin les sorties $Q_1$ et $Q_2$ des bascules sont reliées aux entrées d'une porte "OU EXCLUSIF" référencée 64. La sortie de cette porte délivre le signal de battement $f_B$ qui vaut 2 (f − $f_S$). Les diagrammes des temps de la figure 5b montrent la forme des différents signaux.

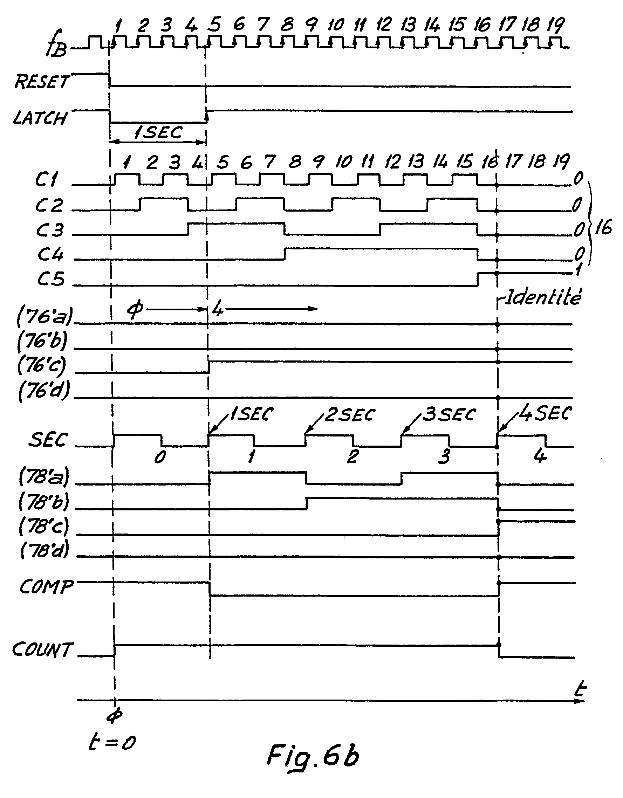

Les figures 6a et 6b illustrent plus en détails une variante de réalisation du circuit d'élaboration du nombre $N_2$ proportionnel au carré de la température, dans le cas où $T_1$ vaut une seconde.

Ce circuit comprend la chaîne de division 70, correspondant au compteur 26 dont on a représenté les sorties d'état binaire $C_1$ à $C_5$ associées aus plus faibles poids binaires et l'entrée de remise à zéro 70b. L'entrée d'horloge 70a de la chaîne de division est attaquée par le signal de battement de fréquence $f_B$ à travers la porte ET référencée 72. Il comporte également une mémoire commandable 74 dont les entrées sont reliés aux sorties $C_1$ à $C_5$ de la chaîne de division 70. Il comprend encore le registre 76 dont les entrées 76a à 76e sont reliées aux sorties 74'a à 74'e de la mémoire 74 et qui comprend en outre l'entrée de remise à zéro 76f et les sorties 76'a à 76'e.

On trouve également le compteur 78 correspondant au compteur 38. Le compteur 78 comporte l'entrée d'horloge 78a, l'entrée de remise à zéro 78b et les sorties d'état 78'a à 78'e. On trouve encore un comparateur 80 comportant une première série d'entrées 80a à 80e reliées aux sorties 78'a à 78'e du compteur 78 et une deuxième série d'entrées 80'a à 80'e reliées aux sorties 76'a à 76'e du registre 76. Le comparateur émet sur sa sortie 80f un signal COMP de niveau logique 1 lorsque les signaux appliqués sur ses deux séries d'entrées sont identiques. Le circuit comprend enfin une porte OU référencée 82 qui reçoit sur une de ses entrées le signal COMP par l'intermédiaire d'un inverseur 84 et sur son autre entrée le signal LATCH qui sera explicité ultérieurement. La sortie de la porte 82 délivre un signal COUNT qui est appliqué à la deuxième entrée de la porte 72.

Les entrées de remise à zéro 78b, 76f et 70b reçoivent le signal binaire RESET. L'entrée 78a du compteur 78 reçoit un signal horaire SEC de période 1 seconde, et l'entrée de commande 74a reçoit le signal LATCH. Les diagrammes de la figure 6b illustrent le fonctionnement de ce circuit dans le cas ou $T_1$ vaut 1 seconde.

Au temps t = o, le signal RESET remet à zéro le compteur 78, le registre 76 et le compteur 70. Le signal LATCH ayant la valeur logique "0", le signal COUNT à la sortie de la porte 82 a le niveau logique "1". La porte 72 est donc débloquée et le compteur 70 est incrémenté par les impulsions du signal de fréquence $f_B$. Le front montant du signal LATCH qui apparaît une seconde après l'instant t = o, puisque $T_1$ vaut 1 seconde, charge dans le registre 76 le contenu actuel du compteur 70, c'est-à-dire le nombre $N_1$. Ce nombre représente le nombre de périodes du signal de battement en une seconde. Le compteur 78 compte les secondes depuis l'instant t = o. Lorsque le comparateur détecte l'égalité entre l'état du registre 76 et le contenu du compteur 78, le signal COMP prend le niveau logique "1". Les deux signaux COMP ET LATCH sont donc au niveau logique "0" et il en est de même du signal COUNT. La porte 72 est fermée et le compteur 70 n'est plus incrémenté. Son contenu $N_2$ vaut alors $f_B N_1$, c'est-à-dire un nombre sensiblement proportionnel au carré du nombre de périodes du signal de fréquence $f_B$ pendent la durée $T_1$ puisque pendant 1 seconde le signal de fréquence $f_B$ peut comporter $N_1$ périodes plus une fraction de période. Comme cela a déjà été expliqué, c'est le nombre $N_2$ proportionnel au carré de l'écart de température qui sert à effectuer la correction à toutes les périodes $T_T$. Dans l'exemple de la figure 6, $N_1$ vaut 4 et $N_2$ vaut 16 puisque $T_1$ vaut une seconde.

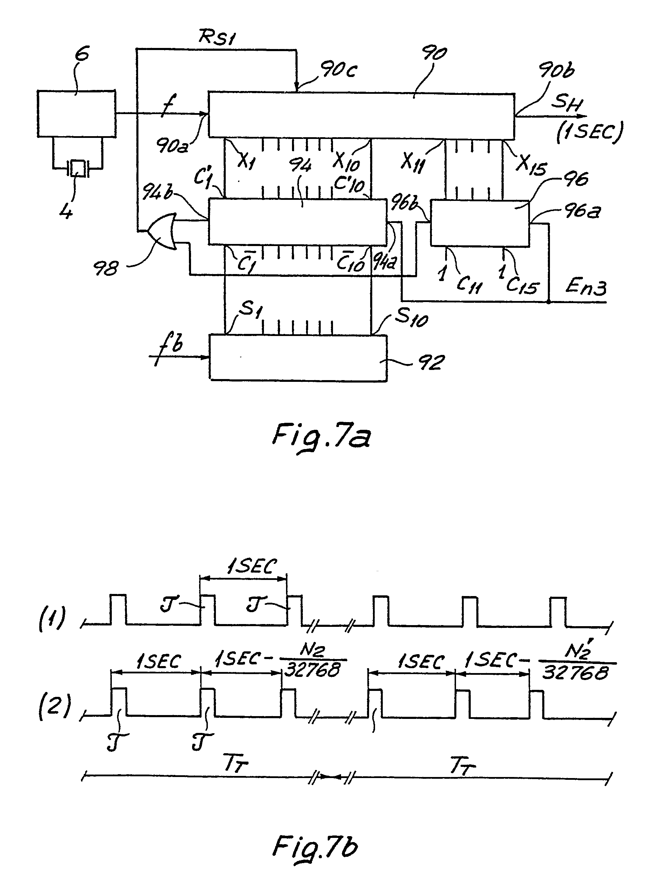

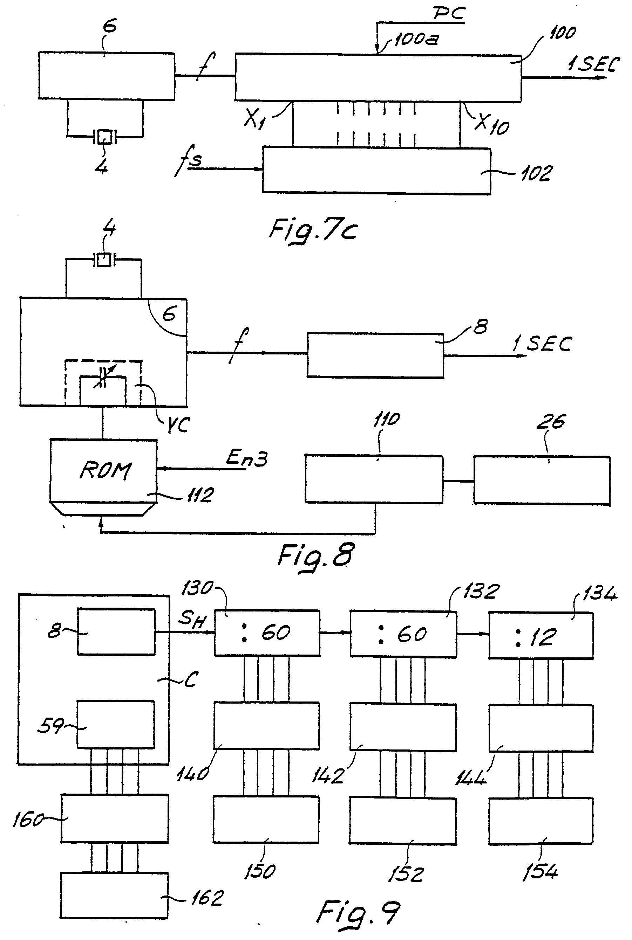

Les figures 7a et 7b illustrent plus en détail le premier mode d'ajustement déjà décrit en liaison avec la figure 4a. Le circuit comprend le diviseur 90 identique au diviseur 8 de la figure 4a. Il reçoit sur son entrée d'horloge 90a le signal de fréquence f délivré par le résonateur 4, 6. Sa sortie 90b délivre le signal horaire $S_H$ dont la période normale vaut ici une seconde. Dans le cas particulier considéré le diviseur 90 délivre une impulsion brève J à la fin de chaque période comme cela est représenté sur la figure 7b.

Le diviseur comporte également les sorties d'état $X_1$ à $X_{15}$ qui donnent ainsi en permanence, sous forme binaire, l'état du diviseur. Le diviseur comporte encore l'entrée de remise à zéro 90c. Le diviseur comporte 15 étages binaires de division pour compter les 32.768 impulsions correspondant à une seconde normale. On trouve également le compteur 92 identique au compteur 26 et qui sert entre autre à élaborer le nombre $N_2$. Le compteur 92 a 10 étages de division et donc 10 sorties de comptage référencées $S_1$ à $S_{10}$. Ce nombre d'étages est suffisant. En effet, le nombre $N_2$ ne peut dépasser 1000.

Le circuit comporte encore un ensemble de comparaison équivalent au comparateur 30 de la figure 4a. Cet ensemble est constitué par le comparateur 94 et le comparateur 96. Le comparateur 94 comprend d'une part des entrées inverseuses $\overline{C}_1$ à $\overline{C}_{10}$ reliées aux sorties de comptage $X_1$ à $X_{10}$ du diviseur 90. Le comparateur 94 comporte en outre une entrée d'activation 94a et une sortie de comparaison 94b. Le comparateur 96 comporte 5 entrées $C_{11}$ à $C_{15}$ du diviseur 90, ces sorties ayant les poids binaires les plus élevés. Le comparateur 96 comporte encore l'entrée d'activation 96a et la sortie de comparaison 96b. Comme dans le cas de la figure 4a, les entrées d'activation 96a et 94a reçoivent le signal $E_{n3}$. De plus, les sorties de comparaison 94b et 96b sont reliées aux entrées d'une porte ET référencée 98 qui délivre un signal RS1 appliqué à l'entrée de remise à zéro 90c du diviseur 90.

L'état des sorties $S_1$ à $S_{10}$ du compteur 92 donne sous forme binaire la valeur du nombre $N_2$. Sur les entrées inverseuses $\overline{C}_1$ à $\overline{C}_{10}$ du comparateur 94, on trouve donc le complément à $2^{10}$ du nombre $N_2$. Par ailleurs, les entrées $C_{11}$ à $C_{15}$ du comparateur 86 sont toutes à 1. Donc le premier groupe d'entrées de l'ensemble de comparaison 94, 96 a sur ses entrées le complément à $2^{15}$ (32.768) de $N_2$. En effet, $N_2$ étant inférieur à 1000, les cinq poids binaires les plus élevés sont nuls si on écrit $N_2$ sous forme binaire. Si on prend le complément à $2^{15}$ de $N_2$, les cinq poids binaires les plus élevés de ce complément valent donc 1.

Sur les entrées $C'_1$ à $C'_{15}$ de l'ensemble de comparaison 94, 96, on a en permanence le contenu du diviseur 90. Ainsi, si l'égalité est constatée lorsque le signal $E_{n3}$ passe au niveau logique "1" sur leurs entrées 94a et 96a, la porte ET référencée 98 délivre un signal RS1 de niveau logique "1" qui remet à zéro le diviseur 90 et une impulsion horaire J est délivrée par la sortie 90b du diviseur. Cette impulsion J est émise lorsque le diviseur 90 a compté 32'768 — $N_2$ impulsions du signal de fréquence fo au lieu des 32.768 impulsions pour une seconde normale. ON voit donc que la "seconde" correspondante a été raccourcie de $N_2/32.768$ seconde. C'est-à-dire que l'ajustement a été effectivement appliqué.

Si l'on reprend le cas général dans lequel l'oscillateur 4, 6 a une fréquence F et le diviseur 90 doit compter N impulsions pour délivrer une période de une seconde, on voit aisément qui la période ajustée est raccourcie de

$$\frac{N2}{N}$$

seconde.

La figure 7b montre le signal horaire $S_H$ non ajusté (1) et le signal $S_H$ ajusté (diagramme 2) de la valeur $N_2$ pendant une période $T_T$ d'ajustement et de la valeur $N'_2$ pendant la période $T_T$ suivante, correspondant à une variation de l'écart de température entre les deux périodes d'ajustement.

La figure 7c illustre une variante de réalisation de la partie du circuit pour ajuster la fréquence à partir du nombre $N_2$ proportionnel au carré de l'écart de température. L'ajustement consiste à raccourcir le temps s'écoulant entre deux impulsions séparées normalement par un intervalle de une seconde en préchargeant le compteur horaire à la valeur $N_2$. Ainsi le temps réel séparant les deux impulsions est raccourci de $N_2/32.768$ seconde.

Pour cela, le circuit comprend un diviseur 100 de capacité $2^{15}$ ayant des entrées de préchargement $X_1$ à $X_{10}$, et une entrée de commande de préchargement 100a. Il joue bien sûr le même rôle que le diviseur 8 de la figure 2.

L'entrée d'horloge du diviseur est reliée à la sortie de l'oscillateur 4, 6. Un compteur 102 à 10 étages de comptage binaire, identique au compteur 26 de la figure 4a, a ses sorties $S_1$ à $S_{10}$ reliées aux entrées de préchargement $X_1$ à $X_{10}$ du diviseur 100. Lorsque la correction doit être appliquée, une impulsion brève de préchargement PC est appliquée sur l'entrée 100a du diviseur entre l'application de la 32.768ième impulsion et l'application de la 32.679ième qui initialise la nouvelle période de "une seconde". On comprend aisément que la durée de cette période de "une seconde" est raccourcie de $N_2/32.768$ seconde.

Si l'on revient à la figure 3, on voit qu'il est en principe nécessaire que la caractéristique II du senseur thermique passe par le point d'inversion $I_1$ de la caractéristique I du résonateur 4. On a déjà expliqué que cette condition n'est pas critique. Cependant, si cette situation optimale ne se présente pas, il existe un moyen simple, selon l'invention, pour décaler parallèlement à l'axe des ordonnées la caractéristique II et amener celle-ci à passer par le point $I_1$. Ce décalage peut se faire en modifiant le nombre d'impulsions du signal de fréquence fo que doit compter le diviseur 8,90 ou 100. Soit M ce nombre d'impulsions par seconde. Pendant la période $T_T$ il faudra donc modifier le nombre d'impulsions de la valeur $M \times T_T = M'$, pour avoir en moyenne sur une période $T_T$ la bonne caractéristique. Il suffit de modifier $N_2$ de M' lorsqu'on effectue la compensation en température.

D'autres avantages de l'invention découlent clairement de la description précédente. Le temps de fonctionnement du circuit de compensation est proportionnel à l'écart entre la température d'inversion et la température ambiante. Dans les conditions normales d'utilisation de la montre, le temps de fonctionnement est donc très limité. En outre le rapport cyclique de fonctionnement de l'ensemble de mesure de température et de correction est très réduit, il est compris entre 0,5% et 3,2%.

Il faut observer ce plus que le senseur thermique n'est associé à aucun diviseur de fréquence et que, parmi les circuits ajoutés à ceux d'une base de temps normale pour montre, seul le générateur de battement est attaqué par des signaux à fréquence élevée. Tout le traitement de l'information pour élaborer $N_2$ se fait à basse fréquence, inférieure à 30 Hz. La consommation est donc limitée. Enfin, comme cela a déjà été souligné, un nombre élevé de composants travaillent séquenciellement pour remplir plusieurs fonctions. La surface du circuit intégré peut donc être réduite.

La figure 8 montre sous une forme simplifiée un deuxième mode d'ajustement de la fréquence en fonction de l'écart de température. On agit directement sur le circuit d'entretien 6. Celui-ci comprend un condensateur à capacité réglable VC servant à ajuster la fréquence f délivrée par l'oscillateur 4, 6. Le nombre $N_2$, calculé par le compteur 26 comme cela a été expliqué en liaison avec la figure 4a, est appliqué à l'entrée d'un circuit d'adressage 110. Une mémoire ROM référencée 112 contient pour chaque adresse une valeur de capacité que peut prendre la capacité VC. Pour chaque valeur de $N_2$, la mémoire ROM commande donc une valeur de capacité correspondant à la correction qui doit être apportée à la fréquence délivrée par l'oscillateur en fonction de l'écart de température. Comme dans le cas du mode de réalisation précédent, le réglage n'est effectué qu'après l'application à la ROM du signal d'activation $E_{n3}$. Cette valeur est maintenue jusqu'à l'application du signal $E_{n3}$ suivant. Il faut bien comprendre que dans ce mode de réalisation, c'est la fréquence f du résonateur 4 qui est directement corrigée. Selon les autres modes de réalisation, la fréquence f n'est pas modifiée, c'est la période moyenne du signal $S_H$ qui est corrigée.

La description précédente correspond au cas où βo est négatif. Dans ce cas, la "seconde" ajustée est plus courte que la seconde normale. Bien entendu, dans le cas où βo est positif, il faut rallonger la "seconde" ajustée' par rapport à la seconde normale. En d'autres termes, il faut ajouter $N_2$ impulsions aux impulsions normalement comptées pour élaborer une période ajustée de "une seconde". La modification correspondante des circuits est à la portée de l'homme de l'art.

On voit que, avec le nombre $N_1$, on dispose d'une grandeur qui est représentative de la température ou plus précisément de l'écart entre la température ambiante $T_a$ et la température d'inversion $T_I$. Dans le cas où la base de temps est utilisée dans un appareil horloger, tel qu'une montre, il est intéressant de profiter de cette valeur $N_1$ pour afficher, en plus du temps, la température.

La valeur de $N_1$ est donnée par l'expression suivante:

$$N_1 = \text{ent}[T_1\, \alpha_s\, f_o T]$$

Si $N_1$ est très supérieur à 1, on peut écrire

$$N_1 = (T_1\, \alpha_s f_o).T$$

Pour que $N_1$ donne effectivement la température, il suffit que $T_1.\alpha_s f$ soit une puissance entière de 10.

Si par exemple, on choisit d'avoir une résolution de 1/10 ième de degré, il faut que: $T_1 \alpha_s f_o) = 10$.

Si on reprend les valeurs déjà mentionnées pour $\alpha_s$ et $f_o$, cela impose une valeur de $T_1$, qu'on appelera $T_H$, égale à 8,97 secondes. On appelera $N'_1$ le nombre de périodes du signal de battement comptées pendant la durée $T_H$.

Sur les figures 4a et 4c, on a représenté certains éléments additionnels qui permettent effectivement d'élaborer le nombre $N'_1$ donnant la température. Le circuit de commande 46 comprend en plus le compteur 53d analogue aux compteurs 53a à 53c, et une mémoire 54d, analogue aux mémoires 54a à 54c, qui est préchargée à la valeur $T_H$ choisie. A l'instant où le circuit 56 de séquencement émet la deuxième impulsion du signal RS2, c'est-à-dire à la fin de la période Td, un signal activation est appliqué au comparateur 53d. Le comparateur 53d compare le nombre binaire appliqué par les BUS 51 et 52 sur sa première série d'entrées au nombre binaire préprogrammé dans la mémoire 54d. Lorsqu'il y a coïncidence, c'est-à-dire lorsqu'il s'est écoulé le temps $T_H$, le circuit 56 émet un signal $E_{n4}$ qui apparaît sur la sortie 46'g du circuit de commande 46 et qui provoque le transfert du contenu actuel du compteur 26 dans une mémoire 57 par le BUS 58. Le signal $E_{n4}$ est représenté sur la fibure 4b. La mémoire contient alors le nombre $N'_1$, c'est-à-dire le nombre de dixièmes de degrés d'écart entre la température d'inversion et la température ambiante, sous forme binaire. En outre, le signal W délivre par le circuit 50 donne le signe de cet écart. Il suffit à l'aide d'une circuit de calcul 59 d'ajouter ou de retrancher l'écart à la température d'inversion, par exemple 25°C, pour obtenir un nomber $N''_1$ donnant la température ambiante au dixième de degré près, sous forme binaire.

La figure 9 montre sous forme simplifiée une montre du type à affichage numérique munie de la base de temps décrite précédemment et permettant de plus l'affichage de la température. On a appelé C la base de temps dans laquelle on a seulement fait apparaître le diviseur 8 délivrant le signal $S_H$ de période une seconde et le circuit de calcul 59 donnant la valeur de la température ambiante sous forme binaire. Le signal $S_H$ est appliqué à l'entrée du compteur des secondes 130, qui est un diviseur par 60. La sortie du compteur 130 est reliée à l'entrée d'horloge du compteur des minutes 132, qui est un diviseur par 60. Enfin, la sortie du compteur 132 est reliée à l'entrée d'horloge du compteur des heures 134 qui est un diviseur par 12. Chaque compteur est associée à un décodeur 140, 142, 144 qui commande une cellule d'affichage, par exemple à cristaux liquides, 150, 152, et 154.

La sortie du circuit de calcul 59 est reliée à un décodeur 160 qui commande une cellule d'affichage 162. Cette cellule affiche ainsi sous forme décimale, la température à un dixième de degré près.

Bien entendu, la montre pourrait être du type analogique à aiguilles. Les impulsions $S_H$ servent à commander le moteur entraînant les aiguilles. Pour afficher la température à partir du nombre $N''_1$, il y a plusieurs possibilités. Soit la montre comporte une cellule d'affichage en plus des aiguilles. On est alors ramené au cas précédent. Soit la montre comporte un deuxième moteur pour entraîner une aiguille supplémentaire se déplaçant devant une graduation représentant les températures. Le moteur est commandé par un nombre d'impulsions proportionnel à $N''_1$. Soit l'affichage de l'heure par les aiguilles est périodiquement interrompu. Le moteur reçoit alors un nombre d'impulsions proportionnel à $N''_1$ pour déplacer l'aiguille des minutes, par exemple, devant une graduation représentant la température. Dans ce dernier cas, il est nécessaire de disposer de compteurs d'impulsions horaires, de compteurs d'impulsions motrices et de comparateurs, pour ne pas perdre l'information horaire durant les phases d'affichage de la température et pour reprendre l'affichage de l'information horaire après chaque phase d'affichage de la température.

**Revendications**

1. Base de temps munie d'une compensation thermique, comprenant:

un premier générateur de fréquence (2) comportant un premier oscillateur (6) muni d'un premier résonateur piézo-électrique (4) et délivrant une premier signal à une première fréquence (f) dépendant de la température,

un deuxième générateur de fréquence (10) comportant un deuxième oscillateur (14) muni d'un deuxième résonateur piézo-électrique (12) et délivrant une deuxième signal (fS) à une deuxième fréquence dépendant également de la température,

des moyens (16) pour élaborer en réponse aux signaux délivrés par lesdits oscillateurs un signal représentatif de la température,

des moyens (18) pour élaborer un signal de correction en réponse audit signal de température, et

des moyens pour ajuster la fréquence du signal délivré par ledit premier générateur de fréquence en réponse audit signal de correction, caractérisée par le fait que ledit deuxième résonateur piézo-électrique est un résonateur du type diapason comportant un quartz qui est excité en torsion et dont la fréquence de vibration varie sensiblement linéairement en fonction de la température dans une plage de températures allant de 0 à 50°C environ.

2. Base de temps selon la revendication 1, caractérisée en ce que ledit deuxième résonateur (12) présente une relation sensiblement linéaire entre la variation relative de fréquence

$$\frac{\Delta f}{f}$$

et la variation de température T par rapport à la température d'inversion du premier résonateur de la forme:

$$\frac{\Delta f}{f} = \alpha_s T + \beta_s T^2,$$

$\alpha_s$ et $\beta_s$ étant des coefficients tels que $\alpha_s$ soit au moins cent fois supérieur à $\beta_s$.

3. Base de temps selon l'une quelconque des revendications 1 et 2, caractérisée en ce que les moyens pour élaborer le signal de température comprennent:

des moyens (16, fig. 5a) pour élaborer un signal périodique de battement (fB) entre lesdits premier et deuxième signaux délivrés par les oscillateurs; et

des moyens (26) pour compter les périodes dudit signal de battement pendant un temps prédéterminé $T_1$.

4. Base de temps selon la revendication 2, caractérisée en ce qu'en outre ledit premier résonateur (4) présente une relation entre la variation relative de fréquence

$$\frac{\Delta f}{f}$$

et la variation T de température par rapport à sa température d'inversion de la forme

$$\frac{\Delta f}{f} = \beta_o\, T^2,$$

$\beta_o$ étant un coefficient de même ordre de grandeur que $\beta_S$.

5. Base de temps selon la revendication 4, caractérisée en ce que les moyens d'élaboration du signal de température comprennent des moyens (16, fig. 5a) pour élaborer un signal périodique de battement (fB) entre les signaux délivrés par lesdits premier et deuxième résonateurs; des moyens (26) pour compter les périodes dudit signal de battement; et des moyens (34) pour mémoriser le nombre $N_1$ des périodes comptées pendant un temps $T_1$, et en ce que les moyens d'élaboration du signal de correction comprennent des moyens (26, fig. 6a) pour mémoriser le nombre de périodes $N_2$ du signal de battement pendant un temps $N_1$ secondes, ce nombre $N_2$ étant représentatif du carré du nombre de périodes du signal de battement pendant le temps $T_1$.

6. Base de temps selon l'une quelconque des revendications 1 à 5, caractérisée en ce que ledit premier générateur de fréquence (2) comprend en outre un diviseur de fréquence (8) pour élaborer au moins un signal horaire de période une seconde en réponse au comptage d'un nombre donné N de périodes du signal délivré par ledit premier résonateur, et en ce que lesdits moyens d'ajustement comprennent ledit diviseur de fréquence (8), des moyens (40) pour élaborer un signal de commande de période $T_T$ supérieure à $N_1$ secondes, et des moyens (fig. 7a) pour modifier périodiquement, avec la période $T_T$, de $N_2$ impulsions les N impulsions normalement comptées par ledit diviseur (8, 90) pour délivrer une période d'une seconde, ladite période ajustée étant modifiée de

$$\frac{N2}{N1}$$

seconde.

7. Base de temps selon la revendication 6, caractérisée en ce que les moyens pour élaborer le signal de commande de période $T_T$ comprennent des moyens pour mémoriser deux valeurs numériques de la période $T_T$, respectivement $T_T+$ et $T_T-$, des moyens (50) pour détecter le signe du signal de battement, et des moyens (40) pour donner à la période $T_T$ une desdites deux valeurs en réponse au signal (W) de détection de signe.

8. Montre électronique, caractérisée en ce qu'elle comprend une base de temps selon l'une quelconque des revendications 5 à 7.

9. Montre selon la revendication 8, caractérisée en ce qu'elle comprend en outre des moyens (53d, 54d) pour mémoriser un nombre $N'_1$ de périodes du signal de battement comptées pendant un temps $T_H$, des moyens (59) pour ajouter au nombre $N'_1$ la valeur de la température d'inversion dudit premier résonateur, ce qui donne un nombre $N''_1$ et des moyens (162) pour afficher ledit nombre $N''_1$.

**Patentansprüche**

1. Bezugssignalgenerator mit einer Temperaturkompensation, der aufweist:
einen ersten Frequenzgenerator (2) mit einem ersten Oszillator (6), der mit einem ersten piezoelektrischen Resonator (4) versehen und ein erstes Signal abgibt mit einer ersten temperaturabhängigen Frequenz f,
einen zweiten Frequenzgenerator (10) mit einem zweiten Oszillator (14) der mit einem zweiten piezoelektrischen Resonator (12) versehen ist und ein zweites Signal fS abgibt mit einer zweiten ebenfalls temperaturabhängigen Frequenz,
eine Anordnung (16) zur Erzeugung eines die Temperatur darstellenden Signals als Funktion der von den Oszillatoren abgegebenen Signale,
eine Anordnung (18) zur Erzeugung eines Korrektursignals als Funktion des Temperatursignals und
eine Anordnung zur Einstellung der Frequenz des vom ersten Frequenzgenerator abgegebenen Signals als Funktion des Korrektursignals,
dadurch gekennzeichnet, daß der zweite piezoelektrische Resonator ein Stimmgabel-Resonator ist, der einen in Torsionsrichtung erregten Quarz aufweist, dessen Schwingungsfrequenz im wesentlichen linear als Funktion der Temperatur variiert, in einem Temperaturbereich von ungefähr 0 bis 50°C.

2. Bezugssignalgenerator nach Anspruch 1, dadurch gekennzeichnet, daß der zweite Resonator (12) eine im wesentlichen lineare Beziehung zwischen der Relativänderung der Frequenz

$$\frac{\Delta f}{f}$$

und der Temperaturänderung T aufweist bezüglich der Inversionstemperatur des ersten Resonator Form:

$$\frac{\Delta f}{f} = \alpha_s T + \beta_s T^2,$$

wobei $\alpha_s$ und $\beta_s$ derartige Koeffizienten sind, daß $\alpha_s$ wenigstens 100mal größer als $\beta_s$ ist.

3. Bezugssignalgenerator nach einem der Ansprüche 1 und 2, dadurch gekennzeichnet, daß die Anordnung zur Erzeugung des Temperatursignals aufweist:
eine Anordnung (16, Figur 5a) zur Erzeugung eines periodischen Schwebungssignals (fB) zwischen den ersten und zweiten von den Oszillatoren stammenden Signalen und
eine Anordnung (26) um die Perioden des Schwebungssignals während einer vorgegebenen Zeit $T_1$ zu zählen.

4. Bezugssignalgenerator nach Anspruch 2, dadurch gekennzeichnet, daß der erste Resonator (4) außerdem eine Beziehung aufweist zwischen der Relativänderung der Frequenz

$$\frac{\Delta f}{f}$$

und der Temperaturänderung T bezüglich seiner Inversionstemperatur der Form

$$\frac{\Delta f}{f} = \beta_0 \, T^2,$$

wobei $\beta_0$ ein Koeffizient derselben Größenordnung wie $\beta_S$ ist.

5. Bezugssignalgenerator nach Anspruch 4, dadurch gekennzeichnet, daß die Anordnung zur Erzeugung des Temperatursignals eine Anordnung (16, Figure 5a) aufweist zur Erzeugung eines periodischen Schwebungssignals fB zwischen den von den ersten und zweiten Resonatoren gelieferten Signalen; eine Anordnung (26) um die Perioden des Schwebungssignals zu zählen und eine Anordnung (34) um die Anzahl $N_1$ der während einer Zeit $T_1$ gezählten Perioden zu speichern und daß die Anordnung zur Erzeugung des Korrektursignals eine Anordnung (26, Figur 6a) aufweist, um die Anzahl der Perioden $N_2$ des Schwebungssignals während einer Zeit von $N_1$ Sekunden zu speichern, wobei die Zahl $N_2$ das Quadrat der Zahl der Perioden des Schwebungssignals während der Zeit $T_1$ darstellt.

6. Bezugssignalgenerator nach einem der Ansprüche 1 bis 5, dadurch gekennzeichnet, daß der erste Frequenzgenerator (2) außerdem einen Frequenzteiler (8) aufweist, um wenigstens ein Zeitsignal mit der Periode einer Sekunde zu erzeugen als Funktion der Zählung einer vorgegebenen Zahl N von Perioden des vom ersten Resonator stammenden Signals und daß die Einstellanordnung diesen Frequenzteiler (8), eine Anordnung (40) zur Erzeugung eines Steuersignals der Periode $T_T$, die größer als $N_1$ Sekunden ist und eine Anordnung (Figur 7a) aufweist, um periodisch mit der Periode $T_T$ mit $N_2$ Impulsen die N Impulse zum verändern, die normalerweise vom Teiler 8, 90 gezählt werden um eine Periode von einer Sekunde zu erzielen, wobei die eingestellte Periode mit

$$\frac{N2}{N1}$$

Sekunden modifiziert wird.

7. Bezugssignalgenerator nach Anspruch 6, dadurch gekennzeichnet, daß die Anordnung zur Erzeugung des Steuersignals der Periode $T_T$ eine Anordnung aufweist zur Speicherung zweier numerischer Werte der Periode $T_T$, bzw. $T_T+$ und $T_T-$, eine Anordnung (50) zur Ermittlung des Vorzeichens des Schwebungssignals und eine Anordnung (40), um der Periode $T_T$ einen dieser Werte zu erteilen als Funktion des Signals W der Vorzeichenfeststellung.

8. Elektronische Uhr, dadurch gekennzeichnet, daß sie einen Bezugssignalgenerator nach einem der Ansprüche 5 bis 8 aufweist.

9. Uhr nach Anspruch 8, dadurch gekennzeichnet, daß sie außerdem eine Anordnung (53d, 54d) aufweist zur Speicherung einer Zahl $N'_1$ von Perioden des Schwebungssignals die während einer Zeit $T_H$ gezählt wurden, eine Anordnung (59) um der Zahl $N'_1$ den Wert der Inversionstemperatur des ersten Resonators hinzuzufügen, um so eine Zahl $N''_1$ zu erhalten und eine Anordnung (162) um diese Zahl $N''_1$ anzuzeigen.

**Claims**

1. Time base provided with temperature compensation comprising:

a first frequency generator (2) including a first oscillator (6) provided with a first piezo-electric resonator (4) and delivering a first signal at a first frequency (f) depending on the temperature,

a second frequency generator (10) including a second oscillator (14) provided with a second piezo-electric resonator (12) and delivering a second signal (fS) at a second frequency depending likewise on the temperature,

means (16) for developing a signal representative of the temperature in response to the signals delivered by said oscillators,

means (18) for developing a correction signal in response to said temperature signal, and

means for adjusting the frequency of the signal delivered by said first frequency generator in response to said correction signal,

characterized by the fact that said second piezo-electric resonator is a resonator of the tuning fork type which is excited in torsion and the frequency of vibration of which varies substantially linearly as a function of the temperature in the range of temperatures extending approximately from 0°—50°C.

2. Time base according to claim 1 characterized in that said second resonator (12) exhibits a substantially linear relationship between the relative frequency variation

$$\frac{\Delta f}{f}$$

and the variation of temperature (T) relative to the inversion temperature of the first resonator in the form

$$\frac{\Delta f}{f} = \alpha_S T + \beta_S T^2,$$

$\alpha_S$ and $\beta_S$ being coefficients such that $\alpha_S$ is at least a hundred times greater than $\beta_S$.

3. Time base according to either of claims 1 or 2 characterized in that the means for developing the temperature signal comprise:

means (16, fig. 5a) for developing a periodic beat signal (fB) between said first and second signals delivered by the oscillators; and

means for counting said periods of said beat signal during a predetermined time $T_1$.

4. Time base according to claim 2 characterized in that in addition said first resonator (4) exhibits a relationship between the relative frequency variation

$$\frac{\Delta f}{f}$$

and the variation of tmperature (T) relative to its inversion temperature of the form

$$\frac{\Delta f}{f} = \beta_o T^2,$$

$\beta_o$ being a coefficient of the same order of magnitude as $\beta_S$.

5. Time base according to claim 4 characterized in that the means for the development of the temperature signal comprise means (16, fig. 5a) for developing a periodic beat signal (fB) between the signals delivered by said first and second resonators;

means (26) for counting the periods of said beat signal; and

means (34) for memorising the number $N_1$ of periods counted during a time $T_1$, and

in that the means for the development of the correction signal comprise means (26, fig. 6a) for memorising the number of periods $N_2$ of the beat signal during a time $N_1$ seconds, such number $N_2$ being representative of the square of the number of periods of the beat signal during the time $T_1$.

6. Time base according to any of claims 1 to 5 characterized in that said first frequency generator (2) comprises in addition a frequency divider (8) for developing at least one clock signal having a one second period in response to the counting of a given number N of periods of the signal delivered by said first resonator and in that said adjustment means comprise said frequency divider (8), means (40) for developing a control signal of a period $T_T$ greater than $N_1$ seconds, and means (fig. 7a) for periodically modifying, with the period $T_T$, by $N_2$ pulses the N pulses normally counted by said divider (8, 90) so as to deliver a period of one second, said adjusted period being modified by

$$\frac{N2}{N1}$$

second.

7. Time base according to claim 6 characterized in that the means for developing the control signal of period $T_T$ comprise means for memorising two digital values of the period $T_T$, respectively $T_T+$ and $T_T-$, means for detecting the sign of the beat signal and means (40) for attributing one of said two values to the period $T_T$ in response to the sign detection signal (W).

8. Electronic watch characterized in that it comprises a time base according to any of claims 5 to 7.

9. Watch according to claim 8 characterized in that it comprises in addition means (53d, 54d) for memorising a number $N'_1$ of periods of the beat signal counted during a time $T_H$, means (59) for adding to the number $N'_1$ the value of the inversion temperature of said first resonator which results in a number $N''_1$ and means (162) for displaying said number $N''_1$.

Fig. 1a

Fig. 1b

Fig. 1c

Fig. 3

0 083 303

Fig. 2

Fig. 10

2

Fig.4a

Fig.4c

Fig.4b

Fig.5a

Fig.5b

$2(f-f_s)=f_F$

Fig.6a

0 083 303

Fig.6b

6

Fig.7a

Fig.7b

7

0 083 303

Fig.7c

Fig.8

Fig.9

8